# EUROPEAN PATENT APPLICATION

(11) **EP 3 225 103 A1**
(43) Date of publication of application: **04.10.2017**
(21) Application number: 17164085.7
(22) Date of filing: 31.03.2017
(51) Int. Cl.: A01G 25/16, G06F 1/16, H05K 5/06

(54) **HOUSING FOR ELECTRONIC SPRINKLER CONTROLLER**

(30) Priority: 01.04.2016 US 201662316974 P
(71) Applicant: Aeon Matrix Inc., Taipei City 114 (TW)
(72) Inventor: TSAI, Ming-Je, Taipei City, Taiwan 114 (CN); LIU, Chiang-Wei, Taipei City, Taiwan 114 (CN)
(74) Representative: Zimmermann, Tankred Klaus

(57) **Abstract**

A housing for an electronic sprinkler controller and the electronic sprinkler controller are disclosed. The electronic sprinkler controller has a first circuit board and a terminal block electrically connected with the first circuit board. The housing includes a back cover, a first front cover attached to the back cover to cover the first circuit board, a terminal block cover, a first seal and a second seal. The first circuit board is disposed on the back cover. The first front cover has an opening to expose the terminal block. The terminal block cover is rotatable between a closed position covering the opening and the terminal block and an open position not covering the opening and the terminal block. The first seal is disposed between the back cover and the front cover, and the second seal is disposed between the front cover and the terminal block cover.

## Description

### BACKGROUND OF THE INVENTION

### Field of Invention

The invention relates to a housing and an electronic device and, in particular, to a housing and an electronic sprinkler controller comprising the same.

### Related Art

Using an electronic device to control lawn sprinklers has several advantages. For example, the electronic device may allow a user to control the sprinklers by simply pressing a button or using an application installed on his or her smartphone, which is more convenient. An electronic device may also automatically adjust the watering schedule according to local weather conditions, which reduces the water usage amount. With the advantages above, electronic sprinkler controllers have become more and more popular especially in regions that suffer from water-shortage problems.

An electronic sprinkler controller typically includes a circuit board having electronic components disposed thereon, terminal blocks for connecting to the control wires of sprinkler valves, and a housing accommodating the circuit board and the terminal blocks. When designing the structure of the electronic sprinkler controller, two design considerations exist. One is that the circuit board accommodated in the housing must be protected from wet weather, which is important when the electronic sprinkler controller is designed for outdoor use. Another is that the user should be able to inspect and change the wiring connections to the sprinkler valves easily to facilitate the installation operation. Sometimes these two design considerations conflict with each other. For example, the terminal blocks for the control wires of the sprinkler valves may be exposed to the outside through an opening of the housing, but this may result in the invasion of the moisture from the opening, which may affect the circuit boards inside the housing.

### SUMMARY OF THE INVENTION

In view of the above, an objective of the invention is to provide a housing for an electronic sprinkler controller that solve the above-mentioned issues.

To achieve the above objective, one embodiment of the invention discloses a housing for an electronic sprinkler controller. The electronic sprinkler controller has a first circuit board and a terminal block electrically connected with the first circuit board for connecting to a control wire from a sprinkler valve. The housing includes a back cover, a first front cover, a terminal block cover, a first seal and a second seal. The first circuit board is disposed on the back cover. The first front cover is attached to the back cover to cover the first circuit board, and has an opening to expose the terminal block. The terminal block cover is rotatable between a closed position covering the opening and the terminal block and an open position not covering the opening and the terminal block. The first seal is disposed between the back cover and the front cover, and the second seal is disposed between the front cover and the terminal block cover.

In one embodiment, the terminal block cover is pivotally connected with the first front cover and is made of transparent material.

In one embodiment, the housing further includes a second front cover attached to the back cover to cover the first front cover and the terminal block cover.

In one embodiment, the sprinkler controller further includes a second circuit board which is disposed on the first circuit board, and the first front cover is uplifted at its center to accommodate the second circuit board.

In one embodiment, the second front cover has a shape of two flat flank surfaces at two sides respectively and a concave portion at the top thereof.

In one embodiment, the first front cover further comprises a front opening at the central uplifted portion of the first front cover to expose at least a portion of the second circuit board.

In one embodiment, the first front cover further comprises at least a clamp which is disposed near the central uplifted portion of the first front cover to clamp the terminal block cover.

In one embodiment, the first seal is fixed to the back cover and forms a closed loop around a portion of the back cover corresponding to the first front cover.

In one embodiment, the second seal is fixed to the first front cover and forms a closed loop around the opening corresponding to the terminal block cover.

To achieve the above objective, one embodiment of the invention discloses an electronic sprinkler controller. The electronic sprinkler controller has a housing, a circuit board, and a terminal block which is electrically connected with the first circuit board and is configured to connect to a control wire from a sprinkler valve. The housing includes a back cover, a first front cover, a terminal block cover, a first seal and a second seal. The first circuit board is disposed on the back cover. The first front cover is attached to the back cover to cover the first circuit board, and has an opening to expose the terminal block. The terminal block cover is rotatable between a closed position covering the opening and the terminal block and an open position not covering the opening and the terminal block. The first seal is disposed between the back cover and the front cover, and the second seal is disposed between the front cover and the terminal block cover.

In one embodiment, the terminal block cover is pivotally connected with the first front cover.

In one embodiment, the terminal block cover is made of transparent material.

In one embodiment, the housing further comprises a second front cover attached to the back cover to cover the first front cover and the terminal block cover.

In one embodiment, the electronic sprinkler controller further includes a second circuit board which is disposed on the first circuit board, and the first front cover is uplifted at its center to accommodate the second circuit board.

In one embodiment, the second front cover has a shape of two flat flank surfaces at two sides respectively and a concave portion at the top thereof.

In one embodiment, the first front cover further comprises a front opening at the central uplifted portion of the first front cover to expose at least a portion of the second circuit board.

In one embodiment, the first front cover further comprises at least a clamp which is disposed near the central uplifted portion of the first front cover to clamp the terminal block cover.

In one embodiment, the first seal is fixed to the back cover and forms a closed loop around a portion of the back cover corresponding to the first front cover.

In one embodiment, the second seal is fixed to the first front cover and forms a closed loop around the opening corresponding to the terminal block cover.

### BRIEF DESCRIPTION OF THE DRAWINGS

FIG. 1 is a schematic exploded diagram of the sprinkler controller according to an embodiment of the invention.
FIG. 2 is a schematic diagram of the sprinkler controller according to an embodiment of the invention with the second front cover being removed and the terminal block cover at its open position.
FIG. 3 is a schematic diagram of the sprinkler controller according to an embodiment of the invention with the second front cover being removed and the terminal block cover at its closed position.
FIG. 4 is a schematic diagram of the sprinkler controller according to an embodiment of the invention.

### DETAILED DESCRIPTION OF THE INVENTION

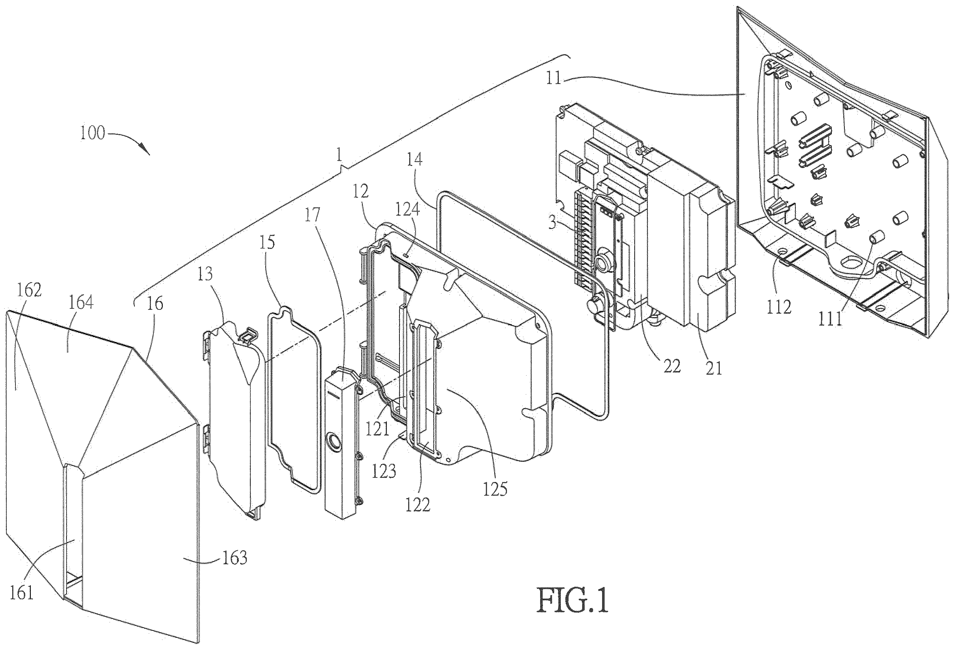

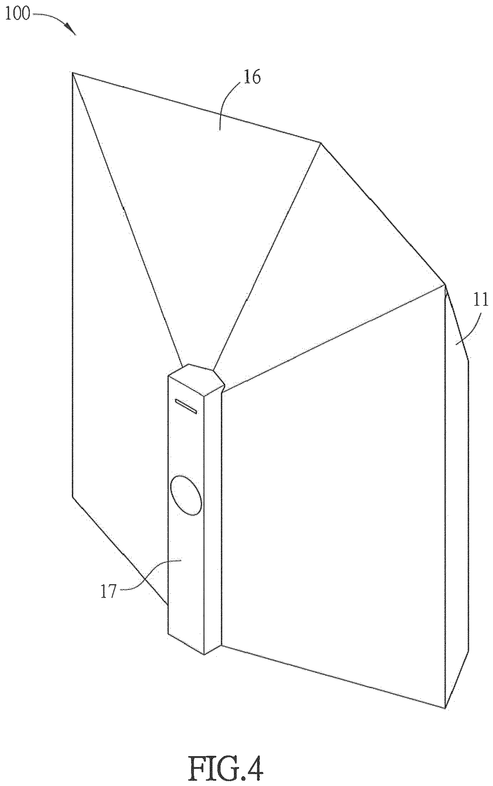

Referring to FIG. 1 to FIG. 4, the sprinkler controller 100 according to an embodiment of the invention includes a housing 1, first circuit board 21, a second circuit board 22 disposed on the first circuit board 21, and a terminal block 3 also disposed on the first circuit board 21. The housing 1 includes a back cover 11, an first front cover 12, a terminal block cover 13, a first seal 14, a second seal 15, an second front cover 16 and a cap 17.

The back cover 11 supports the first circuit board 21. The first circuit board 21 may be fixed to the back cover 11 via screws, clamps or other equivalent means. To support the first circuit board 21 more firmly, the internal surface of the back cover 11 may have projections 111 to touch the back side of the first circuit board 21 when the first circuit board 21 is fixed to the back cover 21. A wire hole 112 is formed at the bottom of the back cover 11 so that the wirings can enter into the housing 1 from the bottom of the back cover 11.

The first circuit board 21 fixed on the back cover 11 may include electronic components that perform the main functions of the sprinkler controller 100, such as a main controller to control the operations of the sprinkler valves, a network module for wired and/or wireless network connections, and/or user interface module to receive the operations from and prompt information to a user.

The second circuit board 22 may include auxiliary electronic components of the sprinkler controller 100, such as a camera module, and may be electrically connected with the first circuit board 21 by a pair of connectors and/or a flexible printed circuit. In the present embodiment, separating the auxiliary electronic components from the main-function components makes the overall architecture of the sprinkler controller 100 more flexible. For example, one can remove the second circuit board 22 to build a cheaper product while maintaining the main functions of the first circuit board 21. One can also replace the second circuit board 22 with another module having another function such as a music playback module or data storage module to build a product with different functionalities.

The first front cover 12 of the housing 1 is fixed to the back cover 11 and covers the first circuit board 21 and the second circuit board 12. In this embodiment, the first front cover 12 is uplifted at its center to accommodate the second circuit board 22. An opening 121 is formed at one side of the first front cover 12 to expose the terminal block 3 disposed on the first circuit board 21. The opening 121 is wide enough to expose the whole terminal block 3 to facilitate the wiring operation of the user.

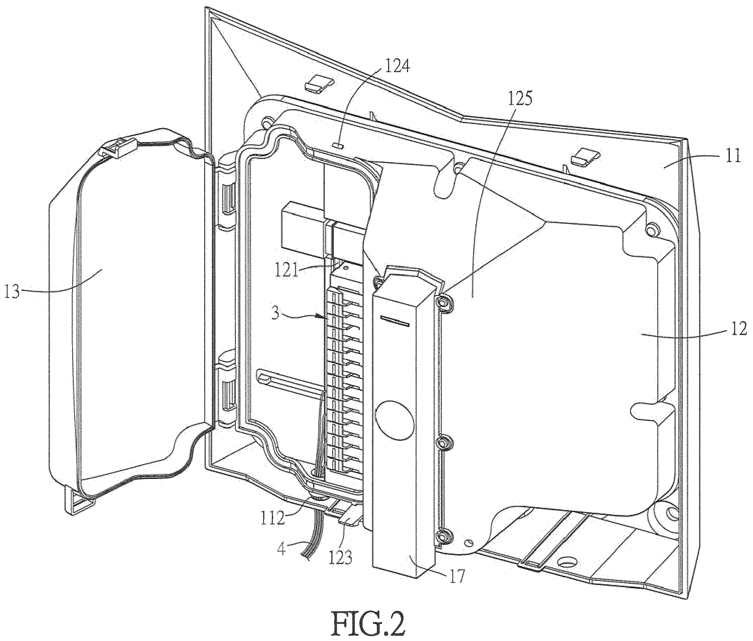

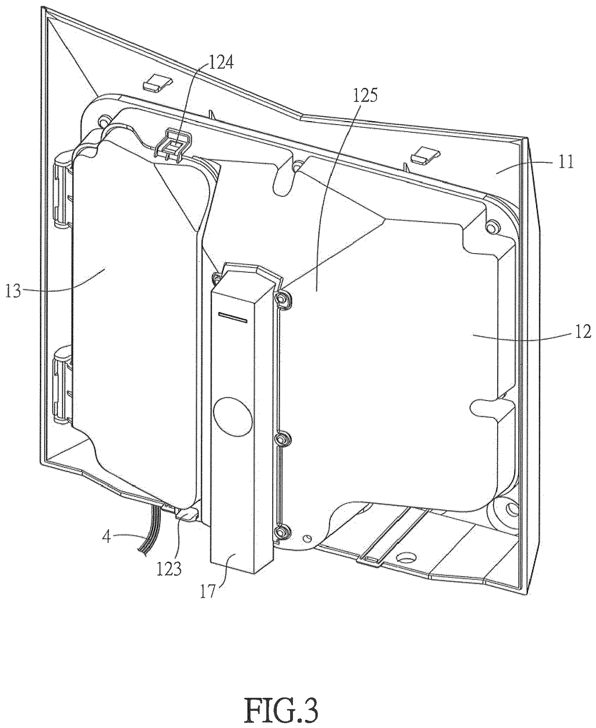

The terminal block cover 13 is pivotally connected to the first front cover 12, and is rotatable between a closed position (shown in FIG. 3) covering the opening 121 and the terminal block 3 and an open position (shown in FIG. 2) not covering the opening 121 and the terminal block 3. In the present embodiment, the terminal block cover 13 is made of transparent material such as transparent plastic or resin. The pivotal axis of the terminal block cover 13 with respective to the first front cover 12 is designed to be located near the edge of the first front cover 12, which is far away from its central uplifted portion 125. Therefore, when the terminal block cover 13 is rotated from its closed position to its open position, the terminal block cover 13 is rotated away from the central uplifted portion 125 of the first front cover 12. A clamp may be provided on the first front cover 12 near its central uplifted portion to clamp the terminal block cover 13 when the terminal block cover 13 is at its closed position covering the opening 121.

The first seal 14 is disposed between the back cover 11 and the first front cover 12, and the second seal 15 is disposed between the first front cover 12 and the terminal block cover 13. In the present embodiment, the first seal 14 is fixed to the back cover 11 by glue and forms a closed loop around the portions of the back cover 11 corresponding to the first front cover 12. The second seal 15 can be fixed to the first front cover 12 by glue and forms a closed loop around the opening 121 corresponding to the terminal block cover 13 when the connecting cover 13 is at its closed position. With such design, since the gaps between the back cover 11 and the first front cover 12 and between the first front cover 12 and the terminal block cover 13 are sealed, the first seal 14 and the second seal 15 can significantly reduce the amount of moisture entering into the accommodating space formed between the back cover 11, the first front cover 12 and the terminal block cover 13.

In the present embodiment, a front opening 122 is formed at the central uplifted portion 125 of the first front cover 12 to expose at least a portion of the second circuit board 22. The cap 17 may be fixed firmly to the first front cover 12 by clamps, screws or glue to cover the front opening 122. When the second circuit board 22 includes a camera module, the cap 17 may be made of semi-transparent material having a dark color so that it is difficult for the user to see the camera module from the outside of the housing 1 while the camera module can still take pictures through the cap 17.

The second front cover 16 may be fixed to the back cover 11 by screws or clamps, and covers the first circuit board 21, the second circuit board 22, the first front cover 12 and the terminal block cover 13. A cap opening 161 is formed on the second front cover 16 corresponding to the position of the cap 17 to expose the cap 17 to the outside of the housing 1. The second front cover 16 has a simple shape of two flat flank surfaces 162 and 163 at two sides respectively and a concave portion 164 at the top.

According to the present embodiment, the first circuit board 21 and the second circuit board 22 are accommodated in the space formed by the back cover 11, the first front cover 12 and the terminal block cover 13. The gaps between the back cover 11, the first front cover 12 and the terminal block cover 13 are sealed by the first seal 14 and the second seal 15, and the cap 17 is fixed firmly to the first front cover 12.

As shown in FIG. 2 and FIG.3, the control wires 4 enter into the housing 1 from the wire hole 112 formed at the bottom of the back cover 11, and reach the terminal block 3 after passing through a gap between the first circuit board 21 and the internal surface of the first front cover 12. When the user needs to change the control wire connections, he or she can simply remove the second front cover 16, and then open the terminal block cover 13 to change the wiring connections at the terminal block 3. After the connections of the control wires 4 being changed, the user can close the terminal block cover 13 and put the second front cover 16 back. With such design, the moisture entering into the housing 1 can be significantly reduced, while at the same time it is still convenient for the user to change the wiring connections.

Note that persons having ordinary skill in the art can alter the design of the housing 1 described above without departing from the spirit and scope of the invention. For example, it is possible that the cap opening 161 is not formed on the second front cover 16; in that case the cap 17 can be removed from the housing 1. It is also possible that the terminal block cover 13 is pivotally connected to the back cover 11 rather than the first front cover 12 to achieve the same functionality.

Therefore, although the invention has been described with reference to specific embodiments, this description is not meant to be construed in a limiting sense. Various modifications of the disclosed embodiments, as well as alternative embodiments, will be apparent to persons skilled in the art. The appended claims therefore will cover all modifications that fall within the true scope of the invention.

## Claims

1. A housing for an electronic sprinkler controller, the electronic sprinkler controller having a first circuit board and a terminal block electrically connected with the first circuit board, the terminal block being configured to connect to a control wire from a sprinkler valve, the housing comprising:
a back cover on which the circuit board and the terminal block are disposed;
a first front cover attached to the back cover to cover the circuit board and having an opening to expose the terminal block;
a terminal block cover being rotatable between a closed position covering the opening and the terminal block and an open position not covering the opening and the terminal block;
a first seal disposed between the back cover and the first front cover; and
a second seal disposed between the first front cover and the terminal block cover.

2. The housing according to claim 1, wherein the terminal block cover is pivotally connected with the first front cover.

3. The housing according to claim 1, wherein the terminal block cover is made of transparent material.

4. The housing according to claim 1, further comprising:
a second front cover attached to the back cover to cover the first front cover and the terminal block cover.

5. The housing according to claim 1, wherein the electronic sprinkler controller further includes a second circuit board which is disposed on the first circuit board, and the first front cover is uplifted at its center to accommodate the second circuit board.

6. The housing according to claim 4, wherein the second front cover has a shape of two flat flank surfaces at two sides respectively and a concave portion at the top thereof.

7. The housing according to claim 5, wherein the first front cover further comprises a front opening at the central uplifted portion of the first front cover to expose at least a portion of the second circuit board.

8. The housing according to claim 5, wherein the first front cover further comprises at least a clamp which is disposed near the central uplifted portion of the first front cover to clamp the terminal block cover.

9. The housing according to claim 1, wherein the first seal is fixed to the back cover and forms a closed loop around a portion of the back cover corresponding to the first front cover.

10. The housing according to claim 1, wherein the second seal is fixed to the first front cover and forms a closed loop around the opening corresponding to the terminal block cover.

11. An electronic sprinkler controller, comprising:
a first circuit board;
a terminal block which is electrically connected with the first circuit board and is configured to connect to a control wire from a sprinkler valve, and
the housing according to any one of claims 1 to 10.
